# EUROPEAN PATENT SPECIFICATION

(11) **EP 1 891 644 B1**
(45) Date of publication and mention of the grant of the patent: **11.02.2009**
(21) Application number: 06773190.1
(22) Date of filing: 13.06.2006
(51) Int. Cl.: G11C 16/34, G11C 11/56

(54) **SELECTIVE SLOW PROGRAMMING CONVERGENCE IN A FLASH MEMORY DEVICE**
SELEKTIVE, LANGSAM PROGRAMMIERBARE KONVERGENZ IN EINER FLASH-SPEICHERVORRICHTUNG
CONVERGENCE SELECTIVE LORS DE LA PROGRAMMATION LENTE D'UNE MEMOIRE FLASH

(30) Priority: 15.06.2005 IT RM20050310; 01.05.2006 US 414982
(43) Date of publication of application: 27.02.2008
(73) Proprietor: Micron Technology, Inc., Boise, ID 83716-9632 (US)
(72) Inventor: INCARNATI, Michele, I-67055 Gioia Del Marsi (AQ) (IT); SANTIN, Giovanni, I-02010 Vazia, RI (IT); VALI, Tommaso, I-04018 Sezze, Latina (IT)
(74) Representative: Beresford, Keith Denis Lewis
(86) International application number: PCT/US2006/023217
(87) International publication number: WO 2006/138413

(56) References cited:
- US-A1- 2004 066 685
- US-B1- 6 888 758
- US-B2- 6 643 188

## Description

### TECHNICAL FIELD OF THE INVENTION

The present invention relates generally to memory devices and in particular the present invention relates to flash memory devices memory devices.

### BACKGROUND OF THE INVENTION

Memory devices are typically provided as internal, semiconductor, integrated circuits in computers or other electronic devices. There are many different types of memory including random-access memory (RAM), read only memory (ROM), dynamic random access memory (DRAM), synchronous dynamic random access memory (SDRAM), and flash memory.

A flash memory is a type of memory that can be erased and reprogrammed in blocks instead of one byte at a time. A typical flash memory comprises a memory array, which includes a large number of memory cells. Each of the memory cells includes a floating gate field-effect transistor capable of holding a charge. The cells are usually grouped into blocks. Each of the cells within a block can be electrically programmed on a random basis by charging the floating gate. The data in a cell is determined by the presence or absence of the charge in the floating gate. The charge can be removed from the floating gate by a block erase operation.

Each memory cell can be programmed as a single bit per cell (i.e., single level cell - SLC) or multiple bits per cell (i.e., multilevel cell- MLC). Each cell's threshold voltage (Vₜ) determines the data that is stored in the cell. For example, in a single bit per cell, a Vₜ of 0.5V can indicate a programmed cell while a Vₜ of -0.5V might indicate an erased cell. The multilevel cell may have multiple Vₜ windows that each indicates a different state. Multilevel cells take advantage of the analog nature of a traditional flash cell by assigning a bit pattern to a specific voltage distribution for the cell. This technology permits the storage of two or more bits per cell, depending on the quantity of voltage ranges assigned to the cell.

It is important that the Vₜ distributions be sufficiently spaced apart so as to reduce the possibility of a higher voltage of one distribution overlapping a lower Vₜ of the next distribution. The overlap can occur due to noise or temperature variations of the integrated circuit. One way to create larger gaps between the various threshold voltage distributions is to make the distributions themselves narrower. This can be a problem since memory cells program at different rates.

Faster memory cells may be programmed before the slower cells since the faster cells require fewer programming pulses. This can result in the Vₜ distribution for the faster cells being different and/or closer to other distributions than slower cells due to the wider - distributions created by faster cells.

One way to solve this problem is illustrated in U.S. Patent No. 6,643,188 to Tanaka et al. and assigned to Toshiba and SanDisk Corporation. Tanaka et al. disclose a two-step programming method that uses first and second step verify voltages. Once a threshold voltage for a memory cell being programmed reaches the first step verify voltage, a write control voltage is changed for all cells being programmed. This slows down the programming of all the memory cells. The preamble of claim 12 is based on this publication.

One problem with this approach is that it reduces programming throughput. Reducing the programming speed of all of the cells being programmed increases the time it takes to program all of the cells, whether they are a fast cell or a slow cell.

Another method that may be used to create narrower distributions is to adjust the programming pulse step voltage as the cell approaches a programmed state. However, this also slows the programming for all of the bits, thus reducing programming throughput. This is especially true for the higher distributions that require additional programming pulses that take longer to reach due to the smaller increment.

For the reasons stated above, and for other reasons stated below which will become apparent to those skilled in the art upon reading and understanding the present specification there is a need in the art for a way to generate narrow Vₜ distributions without reducing the programming throughput of the memory device.

The invention is defined by claims 1 and 12.

### BRIEF DESCRIPTION OF THE DRAWINGS

Figure 1 shows a simplified schematic diagram of one embodiment of a flash memory array of the present invention.
Figure 2 shows a flowchart of one embodiment of a selective slow programming method of the present invention.
Figure 3 shows a diagram of one embodiment of Vₜ distributions of the present invention.
Figure 4 shows a plot of one embodiment of programming pulses, data bit voltage levels, and bit line voltage levels in accordance with the embodiment of Figure 2.
Figure 5 shows a simplified block diagram of one embodiment of a memory system of the present invention.

### DETAILED DESCRIPTION

In the following detailed description of the invention, reference is made to the accompanying drawings that form a part hereof, and in which is shown, by way of illustration, specific embodiments in which the invention may be practiced. In the drawings, like numerals describe substantially similar components throughout the several views. These embodiments are described in sufficient detail to enable those skilled in the art to practice the invention. Other embodiments may be utilized and structural, logical, and electrical changes may be made without departing from the scope of the present invention. The following detailed description is, therefore, not to be taken in a limiting sense, and the scope of the present invention is defined only by the appended claims and equivalents thereof.

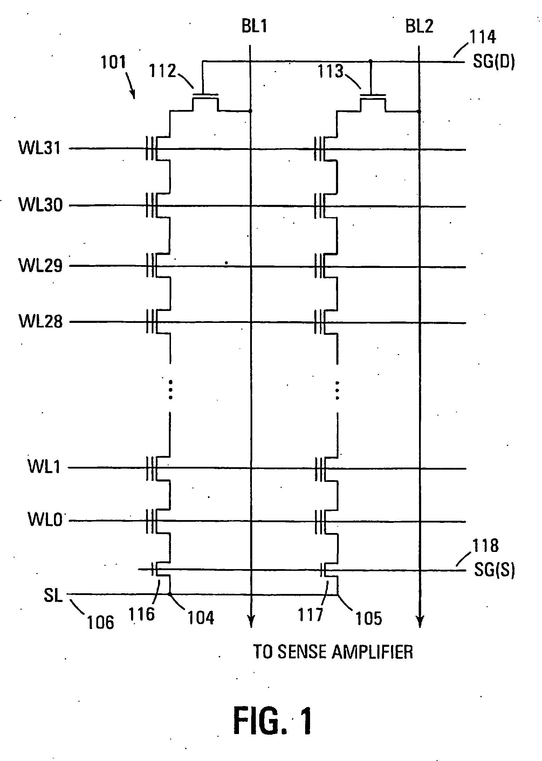

Figure 1 illustrates a simplified diagram of one embodiment for a main NAND flash memory array of the present invention. The memory array of Figure 1, for purposes of clarity, does not show all of the elements typically required in a memory array. For example, only two bit lines are shown (BL1 and BL2) when the number of bit lines required actually depends upon the memory density. The bit lines are subsequently referred to as (BL1 - BLN).

The array is comprised of an array of floating gate cells 101 arranged in series columns 104, 105. Each of the floating gate cells 101 are coupled drain to source in each series chain 104, 105. A word line (WL0 - WL31) that spans across multiple series strings 104, 105 is coupled to the control gates of every floating gate cell in a row in order to control their operation. The bit lines (BL1 - BLN) are eventually coupled to sense amplifiers (not shown) that detect the state of each cell.

In operation, the word lines (WL0 - WL31) select the individual floating gate memory cells in the series chain 104, 105 to be written to or read from and operate the remaining floating gate memory cells in each series string 104, 105 in a pass through mode. Each series string 104, 105 of floating gate memory cells is coupled to a source line 106 by a source select gate 116, 117 and to an individual bit line (BL1 - BLN) by a drain select gate 112, 113. The source select gates 116, 117 are controlled by a source select gate control line SG(S) 118 coupled to their control gates. The drain select gates 112, 113 are controlled by a drain select gate control line SG(D) 114.

During a typical prior art programming operation, the selected word line for the flash memory cell to be programmed is biased with a series of incrementing voltage programming pulses that start at an initial voltage that is greater than a predetermined programming voltage (e.g., approximately 16V). After each programming pulse, a verification operation, with a word line voltage of 0V is performed to determine if the cell's threshold voltage Vₜ has increased to the properly programmed level (e.g., 0.5V).

The unselected word lines for the remaining cells are typically biased at a voltage that is less than the programming voltage (e.g., approximately 10V) during the program operation. In one embodiment, the unselected word line voltages can be any voltage above ground potential. Each of the memory cells is programmed in a substantially similar fashion.

A memory array of the present invention is broken down into memory blocks. The quantity of memory blocks is typically determined by the size of the memory device (i.e., 512 MB, 1 GB). Each memory block is comprised of 64 pages.

The array illustrated in Figure 1 is for a NAND architecture array. The embodiments of the present invention, however, are not limited to any one type of array architecture. For example, the present invention may also operate properly in NOR or AND architecture arrays.

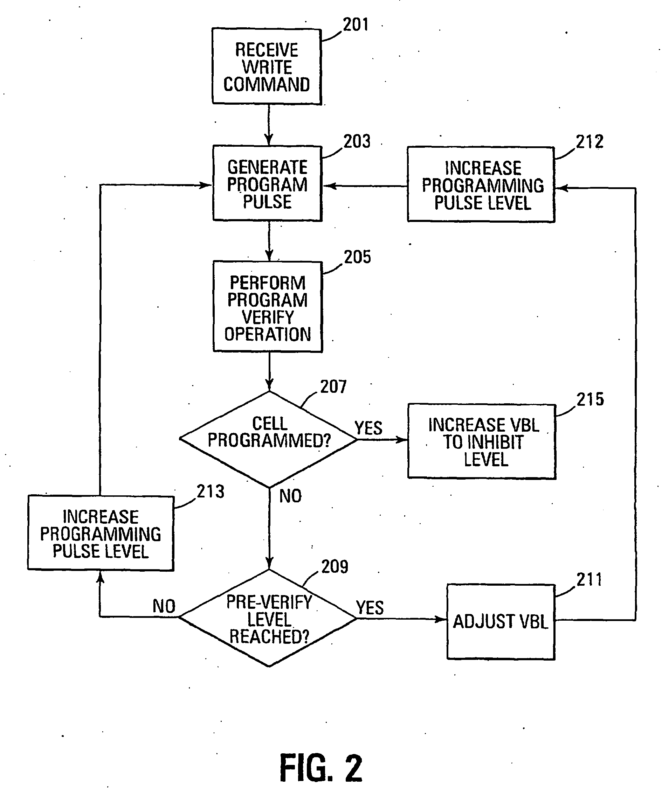

Figure 2 illustrates a flowchart of one embodiment for a selective slow programming convergence method of the present invention. A command is received to write data 201 to one or more memory cells. The data may be a single bit or multiple bits:

As described previously, a programming pulse is generated 203 and applied to the selected word line. A program verify operation is then performed 205 to determine if the cell has been properly programmed 207. The verify operation is simply a read of the cell to determine its contents and a comparison of the read data with the desired data.

If the cell has been programmed, its drain connection (i.e., the bit line to which it is connected) is biased at a program inhibit voltage 215. In one embodiment, V_{BL} is increased from the 0V bit line biasing used during programming to V_{CC}. Alternate embodiments may use other inhibit voltages for V_{BL}.

If the verify operation determines that the cell is not yet programmed with the desired data 207, the threshold voltage for the cell is checked to determine if it has reached a pre-verify voltage level 209 for that particular state. Each state has a pre-verify voltage level at which, when the threshold voltage for that particular state reaches that level, the programming of that particular cell is slowed down by biasing the bit line 211 coupled to the cell.

Unlike the prior art, the method of the present invention selectively slows the programming of each cell that has passed the pre-verify threshold for the particular state being programmed into the cell. Other cells being programmed are unaffected by the bit line biasing and are allowed to be programmed at their normal programming speed. This has the effect of narrowing the Vₜ distribution without reducing the programming throughput.

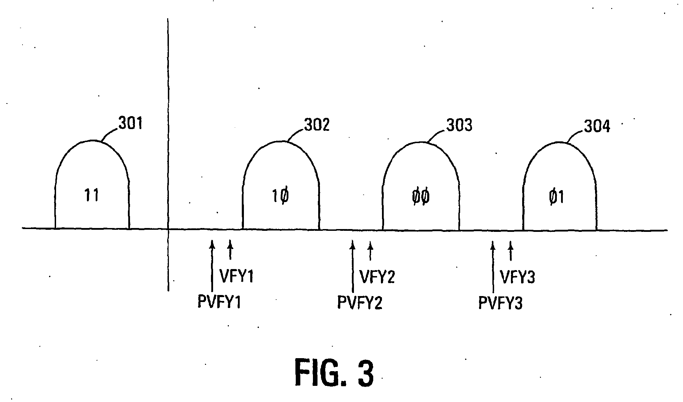

The pre-verify voltage level, as illustrated in Figure 3 and discussed subsequently, is less than the verify voltage level. For example, a first programmed state (i.e., "10") might have a pre-verify voltage of 0.3V and a verify voltage level of 0.5V. Alternate embodiments can use other voltages and different voltage differences between the pre-verify and verify voltages.

The biasing of the bit line reduces the voltage drop across the memory cell transistor, thus reducing the effective programming voltage applied to the cell. The lower the programming voltage, the slower the movement of the Vₜ for that cell. In one embodiment, the bit line bias voltage (V_{BL}) is in a range of 0.5 to 0.9. However, the present invention is not limited to any one voltage or range of voltages.

After the bit line voltage VBL has been increased 211, the programming process repeats by generating another programming pulse 203 that is incrementally larger than the previous pulse 212. In one embodiment, the programming pulses are increased by a 200 mV step voltage. This step voltage is for purposes of illustration only as the present invention can use any step voltage to increase the programming pulse levels.

However, since the voltage drop across the memory cell transistor is now reduced due to the V_{BL} increase, the increased programming pulse voltage will have a reduced effect on programming the cell. The programming operation of that particular state in the cell continues until the cell is programmed and the V_{BL} is increased to the inhibit voltage.

If the pre-verify voltage level has not been reached 207, the programming pulse voltage is increased 213 by the step voltage and the incrementally increase programming pulse is applied to the cell's word line 203. The programming process repeats until the pre-verify voltage level is reached 209, the bit line voltage is adjusted 211 to slow the programming, and the cell is eventually programmed 207 such that the bit line voltage is increased to the inhibit voltage 215.

The method of Figure 2 is performed on each bit in a selective manner. Instead of biasing the bit line of all cells when a bit has reached a pre-verify voltage, only as each cell reaches the pre-verify threshold is its particular bit line voltage increased to slow the programming speed.

In a memory device using multi-level cells, the bits may be located in the same page address or in multiple page addresses. When the bits are in the same page address, both bits can be changed at the same time. In other words, a same page address programming process can go directly from the erased state of "11" to a programmed state of "00". If one or more of the multiple bits are in different page addresses, only one bit at a time is changed. For example, to go from the erased state of "11 " to the programmed state of "'00", it is typically necessary to go through either state "10" or state "01", depending upon where these states are mapped. The selective slow programming convergence method of the present invention works in either of these embodiments.

Figure 3 illustrates a diagram of one embodiment of Vₜ distributions 301- 304 of the present invention. The diagram shows that the erased state "11" 301 is at a negative Vₜ. States "10" 302, "00" 303, and "01" 304 have respectively increasing Vₜ distributions.

Each "non-erased" distribution 302 - 303 has an associated pre-verify voltage (PVFY1 - PVFY3) as discussed previously. Each "non-erased" state 302 - 304 also has a verify voltage (VFY1 - VFY3) that is larger than the pre-verify voltage.

The diagram of Figure 3 is for purposes of illustration only as the selective slow programming convergence method of the present invention is not limited to just the quantity of illustrated states or the particular mapped Vₜ location of each state. The present invention is not related to the particular binary coding of a distribution but generally to the transition from a generic distribution to a different distribution having a higher Vₜ.

For example, in an alternate embodiment, the multi-level cells can have more than two bits thus necessitating additional distributions. In yet another embodiment, each state may be mapped to a different location. For example, state "10" may be mapped to the higher Vₜ distribution and state "01" mapped to the lower Vₜ distribution. The embodiments of the present invention can operate properly in any such instances.

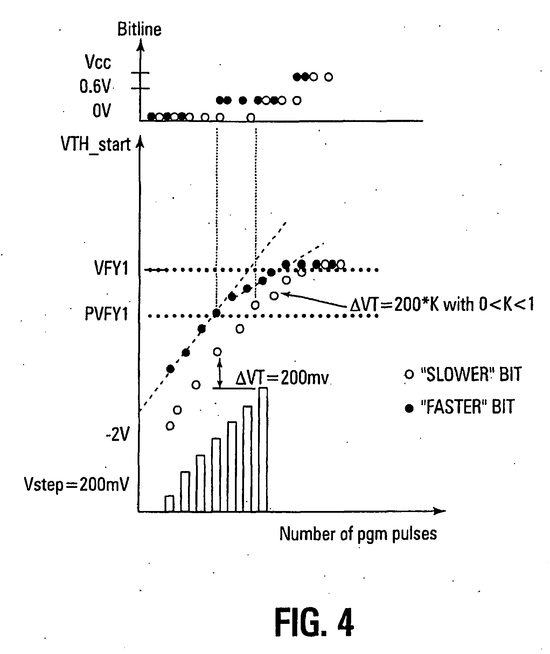

Figure 4 illustrates a plot of one embodiment of programming pulses with resulting data bit voltage levels and bit line voltage levels in accordance with the selective slow programming convergence method of Figure 2. The lower plot shows the programming pulses with the voltage level of each pulse increasing by Vₛₜₑₚ along the bottom axis. The illustrated embodiment uses a Vₛₜₑₚ of 200 mV. However, the present invention is not limited to any one step voltage.

The circles represent two bits that program at different rates. The solid circle programs at a faster rate than the hollow circle. The upward movement of the circles represents an increasing Vₜ. Prior to the PVFY1 threshold, the slower bit is increasing at a ΔVₜ of 200 mV. The solid circle (i.e., faster bit) reaches the pre-verify voltage first. In the illustrated embodiment, this is shown as PVFY1 as discussed in Figure 3. However, this could also be any of the other pre-verify levels such as PVFY2 - 3.

When the faster bit reaches the pre-verify voltage threshold, the upper graph shows that a voltage of approximately 0.6V is applied to the bit line. The bit line of the slower bit is still at 0V.

The middle graph shows that the "faster" bit is now increasing at a slower rate that can be represented by ΔVₜ = 200*K where 0 <K < 1 when the step voltage is equal to 200 mV. Alternate step voltages would have a different ΔVₜ.

Once both the slower bit and the faster bit reach the verify voltage threshold VFY1, the upper graph shows that an inhibit voltage of V_{CC} is applied to the bit line. The middle graph then shows that the increase of the Vt of each bit has stopped due to the end of the programming operation.

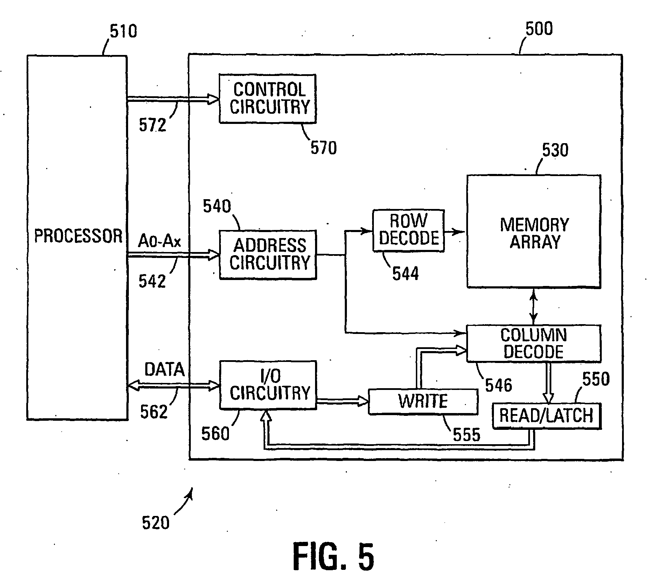

Figure 5 illustrates a functional block diagram of a memory device 500 of one embodiment of the present invention that is coupled to a processor 510. The processor 510 may be a microprocessor, a processor, or some other type of controlling circuitry. The memory device 500 and the processor 510 form part of an electronic system 520. The memory device 500 has been simplified to focus on features of the memory that are helpful in understanding the present invention.

The memory device includes an array of memory cells 530. In one embodiment, the memory cells are non-volatile floating-gate memory cells and the memory array 530 is arranged in banks of rows and columns.

An address buffer circuit 540 is provided to latch address signals provided on address input connections A0-Ax 542. Address signals are received and decoded by a row decoder 544 and a column decoder 546 to access the memory array 530. It will be appreciated by those skilled in the art, with the benefit of the present description, that the number of address input connections depends on the density and architecture of the memory array 530. That is, the number of addresses increases with both increased memory cell counts and increased bank and block counts.

The memory device 500 reads data in the memory array 530 by sensing voltage or current changes in the memory array columns using sense/latch circuitry 550. The sense/latch circuitry, in one embodiment, is coupled to read and latch a row of data from the memory array 530. Data input and output buffer circuitry 560 is included for bi-directional data communication over a plurality of data connections 562 with the controller 510). Write circuitry 555 is provided to write data to the memory array.

Control circuitry 570 decodes signals provided on control connections 572 from the processor 510. These signals are used to control the operations on the memory array 530, including data read, data write, and erase operations. In one embodiment, the control circuitry 570 executes the embodiments of the selective slow programming convergence method of the present invention. The control circuitry 570 may be a state machine, a sequencer, or some other type of controller.

The flash memory device illustrated in Figure 5 has been simplified to facilitate a basic understanding of the features of the memory. A more detailed understanding of internal circuitry and functions of flash memories are known to those skilled in the art.

### CONCLUSION

In summary, the embodiments of the present invention provide an improved method for reducing the width of the Vₜ distributions without reducing the programming throughput. This is accomplished by selectively biasing the bit lines of each cell being programmed as the Vₜ of each cell reaches a pre-verify voltage level that is less than the verify voltage level used by a program verify operation.

The embodiments of the present invention are not limited to any one type of memory technology. For example, the circuits and methods of the present invention may be implemented in a NOR-type flash memory device, a NAND-type flash memory device, or any other type memory device that can be constructed with such a memory array.

Although specific embodiments have been illustrated and described herein, it will be appreciated by those of ordinary skill in the art that any arrangement that is calculated to achieve the same purpose may be substituted for the specific embodiments shown. Many adaptations of the invention will be apparent to those of ordinary skill in the art. Accordingly, this application is intended to cover any adaptations or variations of the invention. It is manifestly intended that this invention be limited only by the following claims and equivalents thereof.

## Claims

1. A method for selectively slow programming convergence in a memory device comprising an array of memory cells having word lines and bit lines, the method comprising:
increasing a threshold voltage for each of a plurality of memory cells; and
selectively biasing bit lines coupled to the plurality of memory cells such that a bit line is biased with a voltage greater than 0V when the threshold voltage of a memory cell that is coupled to the bit line reaches a first verify threshold voltage (PVFY1) of two verify threshold voltages, the first verify threshold voltage being less than the second verify threshold voltage (VFY1).

2. The method of claim 1 wherein increasing the threshold voltage comprises generating a plurality of programming pulses on a predetermined word line coupled to the memory cell being programmed.

3. The method of claim 1 and further including biasing remaining bit lines at ground potential such that memory cells having a threshold voltage below the first verify threshold voltage are programmed at a faster rate than the memory cell coupled to the first bit line.

4. The method of claim 1 and further including performing a verify operation to determine the threshold voltage for each memory cell being programmed.

5. The method of claim 1 wherein the memory device comprises a flash memory device.

6. The method of claim 5 wherein the flash memory device is one of a NAND - type flash memory or a NOR - type flash memory.

7. The method of claim 1 wherein the second verify threshold voltage is a threshold voltage at which the memory cell is considered to be programmed.

8. The method of claim 1 wherein the threshold voltage is part of a threshold voltage distribution indicating one of a plurality of possible multilevel states programmable into the memory cell.

9. The method of claim 1 and further comprising:
performing a programming operation on each of a plurality of memory cells; and
performing a verify operation on each of the plurality of memory cells to determine its respective threshold voltage.

10. The method of claim 9 wherein performing the programming operation comprises generating a plurality of programming voltage pulses that increase incrementally by a step voltage.

11. The method of claim 9 and further including selectively biasing bit lines, coupled to the plurality of memory cells, with an inhibit voltage in response to a memory cell associated with the bit line having a threshold voltage at least equal to the second verify threshold voltage.

12. A memory device comprising:
an array of memory cells having word lines and bit lines, each memory cell having an associated threshold voltage; and
control circuitry that controls programming of the array of memory cells, the control circuitry configured to control generation of a plurality of programming pulses to increase the associated threshold voltages of a set of memory cells to be programmed, **characterized in that** the control circuitry further configured to selectively control bit line biasing to a voltage greater than OV when the threshold voltage of a memory cell coupled to the bit line is equal to or greater than a first verify threshold voltage but less than a second verify threshold voltage.

13. The device of claim 12 wherein the array of memory cells is comprised of floating gate field effect transistors.

14. The device of claim 12 wherein a threshold voltage that is equal to or greater than the second verify threshold voltage is indicative of a programmed memory cell.

15. The device of claim 12 wherein the control circuitry is further configured to control generation of additional programming pulses, increasing by a predetermined step voltage from a previous programming pulse, in response to threshold voltages that are less than the second verify threshold voltage.

16. The device of claim 12 wherein the control circuitry is further adapted to bias, at 0V, all bit lines associated with memory cells having threshold voltages that have not yet reached the first verify threshold voltage.

17. A memory system comprising:
a processor that generates memory program signals; and
a memory device according to claim 12 and coupled to the processor that operates in response to the memory program signals.

## Patentansprüche

1. Verfahren zur selektiven langsamen Programmierkonvergenz in einer Speichervorrichtung mit einem Array von Speicherzellen, die Wortleitungen und Bitleitungen aufweisen, wobei in dem Verfahren:
eine Schwellenspannung für jede der mehreren Speicherzellen erhöht wird; und
an die mehreren Speicherzellen angeschlossene Bitleitungen selektiv unter Spannung gesetzt werden, so dass eine Bitleitung mit einer Spannung von mehr als 0 V beaufschlagt ist, wenn die Schwellenspannung einer an die Bitleitung angeschlossenen Speicherzelle eine erste (PVFY1) von zwei Verifikations-Schwellenspannungen erreicht, wobei die erste Verifikations-Schwellenspannung kleiner ist als die zweite Verifikations-Schwellenspannung (VFY1).

2. Verfahren nach Anspruch 1, wobei beim Erhöhen der Schwellenspannung mehrere Programmierpulse auf einer vorbestimmten Wortleitung erzeugt werden, die an die programmierte Speicherzelle angeschlossen ist.

3. Verfahren nach Anspruch 1, wobei ferner verbleibende Bitleitungen auf Erdungspotential gelegt werden, so dass Speicherzellen mit einer Schwellenspannung unterhalb der ersten Verifikations-Schwellenspannung mit einer schnelleren Rate programmiert werden als die an die erste Bitleitung angeschlossene Speicherzelle.

4. Verfahren nach Anspruch 1, wobei ferner eine Verifikationsoperation ausgeführt wird, um die Schwellenspannung für jede programmierte Speicherzelle zu bestimmen.

5. Verfahren nach Anspruch 1, wobei die Speichervorrichtung eine Flashspeichervorrichtung aufweist.

6. Verfahren nach Anspruch 5, wobei die Flashspeichervorrichtung in einem NAND-Flashspeicher oder einem NOR-Flashspeicher besteht.

7. Verfahren nach Anspruch 1, wobei die zweite Verifikations-Schwellenspannung eine Schwellenspannung ist, bei der die Speicherzelle als programmiert betrachtet wird.

8. Verfahren nach Anspruch 1, wobei die Schwellenspannung Teil einer Schwellenspannungsverteilung ist, die einen mehrerer möglicher Mehrfachniveau-Zustände anzeigt, die in der Speicherzelle programmierbar sind.

9. Verfahren nach Anspruch 1, wobei ferner:
eine Programmieroperation in jeder der mehreren Speicherzellen ausgeführt wird; und
eine Verifikationsoperation in jeder der mehreren Speicherzellen ausgeführt wird, um deren jeweiligen Schwellenwert zu bestimmen.

10. Verfahren nach Anspruch 9, wobei beim Durchführen der Programmieroperation mehrere Programmierspannungspulse erzeugt werden, die sich schrittweise um eine Stufenspannung erhöhen.

11. Verfahren nach Anspruch 9, wobei ferner selektiv Bitleitungen, die an die mehreren Speicherzellen angeschlossen sind, mit einer Sperrspannung beaufschlagt werden, falls eine der Bitleitung zugeordnete Speicherzelle eine Schwellenspannung aufweist, die wenigstens so groß ist wie die zweite Verifikations-Schwellenspannung.

12. Speichervorrichtung mit:
einem Array von Speicherzellen, die Wortleitungen und Bitleitungen aufweisen, wobei jeder Speicherzelle eine Schwellenspannung zugeordnet ist; und
einer Steuerschaltung, die die Programmierung des Arrays von Speicherzellen steuert und die dazu ausgelegt ist, die Erzeugung von mehreren Programmierpulsen zu steuern, um die zugeordneten Schwellenspannungen einer Reihe von zu programmierenden Speicherzellen zu erhöhen, **dadurch gekennzeichnet, dass** die Steuerschaltung ferner dazu ausgelegt ist, selektiv das Beaufschlagen einer Bitleitung mit einer Spannung zu steuern, die größer als 0 V ist, wenn die Schwellenspannung einer an die Bitleitung angeschlossenen Speicherzelle mindestens so groß ist wie eine erste Verifikations-Schwellenspannung aber geringer als eine zweite Verifikations-Schwellenspannung.

13. Vorrichtung nach Anspruch 12, wobei das Array von Speicherzellen aus Floating-gate-Feldeffekttransistoren aufgebaut ist.

14. Vorrichtung nach Anspruch 12, wobei eine Schwellenspannung, die mindestens so groß ist wie die zweite Verifikations-Schwellenspannung eine programmierte Speicherzelle anzeigt.

15. Vorrichtung nach Anspruch 12, wobei die Steuerschaltung ferner dazu ausgelegt ist, die Erzeugung von zusätzlichen Programmierpulsen zu steuern, die sich von einem vorigen Programmierpuls um eine vorbestimmte Stufenspannung erhöhen, falls die Schwellenspannungen geringer sind als die zweite Verifikations-Schwellenspannung.

16. Vorrichtung nach Anspruch 12, wobei die Steuerschaltung ferner dazu ausgelegt ist, alle Bitleitungen, die Speicherzellen mit Schwellenspannungen zugeordnet sind, die die erste Verifikations-Schwellenspannung noch nicht erreicht haben, mit 0 V zu beaufschlagen.

17. Speichersystem mit:
einem Prozessor, der Speicherprogrammiersignale erzeugt; und
einer Speichervorrichtung gemäß Anspruch 12, die an den Prozessor angeschlossen ist und gemäß der Speicherprogrammiersignale arbeitet.

## Revendications

1. Procédé pour une programmation lente sélective d'une convergence dans un dispositif à mémoire comportant une matrice de cellules de mémoire ayant des lignes de mots et des lignes de bits, le procédé comprenant :
l'augmentation d'une tension de seuil pour chacune de multiples cellules de mémoire ; et
la polarisation sélective de lignes de bits couplées aux multiples cellules de mémoire de manière qu'une ligne de bits soit polarisée avec une tension supérieure à 0 volt lorsque la tension de seuil d'une cellule de mémoire qui est couplée à la ligne de bits atteint une première tension de seuil de vérification (PVFY1) de deux tensions de seuil de vérification, la première tension de seuil de vérification étant inférieure à la seconde tension de seuil de vérification (VFY1).

2. Procédé selon la revendication 1, dans lequel l'augmentation de la tension de seuil comprend la génération de plusieurs impulsions de programmation sur une ligne de mots prédéterminée couplée à la cellule de mémoire en cours de programmation.

3. Procédé selon la revendication 1, et comprenant en outre la polarisation des lignes de bits restantes au potentiel de la masse de manière que les cellules de mémoire ayant une tension de seuil inférieure à la première tension de seuil de vérification soient programmées à une vitesse supérieure à celle de la cellule de mémoire couplée à la première ligne de bits.

4. Procédé selon la revendication 1, et comprenant en outre l'exécution d'une opération de vérification pour déterminer la tension de seuil pour chaque cellule de mémoire en cours de programmation.

5. Procédé selon la revendication 1, dans lequel le dispositif à mémoire comprend un dispositif à mémoire flash.

6. Procédé selon la revendication 5, dans lequel le dispositif à mémoire flash est l'un d'une mémoire flash de type NON-ET et d'une mémoire flash de type NON-OU.

7. Procédé selon la revendication 1, dans lequel la seconde tension de seuil de vérification est une tension de seuil à laquelle la cellule de mémoire est considérée comme étant programmée.

8. Procédé selon la revendication 1, dans lequel la tension de seuil fait partie d'une distribution de tensions de seuil indiquant l'un de plusieurs états possibles de niveaux multiples programmables dans la cellule de mémoire.

9. Procédé selon la revendication 1, et comprenant en outre :
l'exécution d'une opération de programmation sur chacune de multiples cellules de mémoire ; et
l'exécution d'une opération de vérification sur chacune des multiples cellules de mémoire pour déterminer sa tension de seuil respective.

10. Procédé selon la revendication 9, dans lequel l'exécution de l'opération de programmation comprend la génération de plusieurs impulsions de tension de programmation qui augmentent incrémentiellement par pas de tension.

11. Procédé selon la revendication 9, et comprenant en outre la polarisation sélective de lignes de bits, couplées aux multiples cellules de mémoire, avec une tension d'inhibition en réponse au fait qu'une cellule de mémoire associée à la ligne de bits a une tension de seuil au moins égale à la seconde tension de seuil de vérification.

12. Dispositif à mémoire comportant :
une matrice de cellules de mémoire ayant des lignes de mots et des lignes de bits, chaque cellule de mémoire ayant une tension de seuil qui lui est associée ; et
un circuit de commande qui commande la programmation de la matrice de cellules de mémoire, le circuit de commande étant configuré pour commander la génération de plusieurs impulsions de programmation afin d'augmenter les tensions de seuil associées d'un ensemble de cellules de mémoire devant être programmées, **caractérisé en ce que** le circuit de commande est en outre configuré pour commander sélectivement la polarisation d'une ligne de bits à une tension supérieure à 0 volt lorsque la tension de seuil d'une cellule de mémoire couplée à la ligne de bits est égale ou supérieure à une première tension de seuil de vérification, et inférieure à une seconde tension de seuil de vérification.

13. Dispositif selon la revendication 12, dans lequel la matrice de cellules de mémoire est constituée de transistors à effet de champ à grille flottante.

14. Dispositif selon la revendication 12, dans lequel une tension de seuil qui est égale ou supérieure à la seconde tension de seuil de vérification, est représentative d'une cellule de mémoire programmée.

15. Dispositif selon la revendication 12, dans lequel le circuit de commande est en outre configuré pour commander la génération d'impulsions de programmation supplémentaires, augmentant d'un pas de tension prédéterminé par rapport à une impulsion précédente de programmation, en réponse à des tensions de seuil qui sont inférieures à la seconde tension de seuil de vérification.

16. Dispositif selon la revendication 12, dans lequel le circuit de commande est en outre conçu pour polariser à 0 volt toutes les lignes de bits associées à des cellules de mémoire ayant des tensions de seuil qui n'ont pas encore atteint la première tension de seuil de vérification.

17. Système de mémoire comportant :
un processeur qui génère des signaux de programmation de mémoire ; et
un dispositif à mémoire selon la revendication 12 et couplé au processeur qui fonctionne en réponse aux signaux de programmation de mémoire.
